(19) Europäisches Patentamt / European Patent Office / Office européen des brevets

(11) **EP 4 022 365 B1**

(12) **EUROPÄISCHE PATENTSCHRIFT**

(45) Veröffentlichungstag und Bekanntmachung des Hinweises auf die Patenterteilung:
**05.11.2025 Patentblatt 2025/45**

(21) Anmeldenummer: **20744010.8**

(22) Anmeldetag: **20.07.2020**

(51) Internationale Patentklassifikation (IPC):
**G02B 5/18** $^{(2006.01)}$ **G02B 27/10** $^{(2006.01)}$
**G02B 27/42** $^{(2006.01)}$ **G02B 5/08** $^{(2006.01)}$
**G02B 5/09** $^{(2006.01)}$ **G03F 7/00** $^{(2006.01)}$
**G03F 7/20** $^{(2006.01)}$ **G21K 1/06** $^{(2006.01)}$
**H05G 2/00** $^{(2006.01)}$

(52) Gemeinsame Patentklassifikation (CPC):
**G03F 7/70175; G02B 5/0891; G02B 5/09; G02B 5/1838; G02B 5/1861; G02B 27/1086; G02B 27/425; G03F 7/70158; G03F 7/70191; G03F 7/70575; H05G 2/009;** G21K 1/062; G21K 2201/067

(86) Internationale Anmeldenummer:
**PCT/EP2020/070424**

(87) Internationale Veröffentlichungsnummer:
**WO 2021/037437 (04.03.2021 Gazette 2021/09)**

(54) **OPTISCHE BEUGUNGSKOMPONENTE**

OPTICAL DIFFRACTION COMPONENT

COMPOSANT DE DIFFRACTION OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2019 DE 102019213063**

(43) Veröffentlichungstag der Anmeldung:
**06.07.2022 Patentblatt 2022/27**

(73) Patentinhaber: **Carl Zeiss SMT GmbH**
**73447 Oberkochen (DE)**

(72) Erfinder: **FELDMANN, Heiko**
**73430 Aalen (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
WO-A2-2014/114405

• FEIGL TORSTEN ET AL: "Sub-aperture EUV collector with dual-wavelength spectral purity filter", PROCEEDINGS OF SPIE, IEEE, US, vol. 9422, 16 March 2015 (2015-03-16), pages 94220E - 94220E, XP060051569, ISBN: 978-1-62841-730-2, DOI: 10.1117/12.2175666
• VILLE KETTUNEN ET AL: "Diffractive elements designed to suppress unwanted zeroth order due to surface depth error", JOURNAL OF MODERN OPTICS, vol. 51, no. 14, 20 September 2004 (2004-09-20), LONDON, GB, pages 2111 - 2123, XP055682927, ISSN: 0950-0340, DOI: 10.1080/09500340408232517

**Beschreibung**

Die Erfindung betrifft eine optische Beugungskomponente.

Ferner betrifft die Erfindung einen EUV-Kollektor einer Projektionsbelichtungsanlage mit einer derartigen optischen Beugungskomponente, ein Beleuchtungssystem mit einem derartigen EUV-Kollektor, ein optisches System mit einem derartigen Beleuchtungssystem, eine Projektionsbelichtungsanlage mit einem derartigen optischen System sowie ein Verfahren zur Herstellung eines strukturierten Bauteils mit Hilfe einer derartigen Projektionsbelichtungsanlage.

Ein EUV-Kollektor mit einer optischen Beugungskomponente in Form eines optischen Gitters ist bekannt aus der WO 2017/207401 A1 und aus der WO 2014/114405 A2. Ausführungen von optischen Gittern zur Unterdrückung von IR-Wellenlängen in EUV-Projektionsbelichtungsanlagen sind bekannt aus der Veröffentlichung "Multilayer EUV optics with integrated IR-suppression gratings", T. Feigl et al., 2016 EUVL Workshop, Berkeley, June 13-16, 2016. Die Veröffentlichung "Sub-aperture EUV collector with dual-wavelength spectral purity filter", T. Feigl et al., proceedings of SPIE, IEEE, US, Bd. 9422, 16. März 2015, Seiten 94220E-94220E, DOI: 10.1117/12.2175666, ISBN: 978-1-62841-730-2 offenbart einen EUV-Kollektor mit einem optischen Gitter. Die EP 1 540 423 B1 beschreibt einen gitterbasierten spektralen Filter zur Unterdrückung von Strahlung außerhalb eines Nutzbandes in einem EUV-Lithographiesystem. Die US 2014/0131586 A1 beschreibt ein Phasengitter für ein Maskeninspektionssystem. Die DE 10 2009 044 462 A1 beschreibt ein optisches Filterelement mit einer Gitterstruktur zum Beugen von infraroter Strahlung innerhalb eines EUV-Beleuchtungsystems. Der Fachartikel "Multilevel blazed gratings in resonance domain: an alternative to the classical fabrication approach" von M. Oliva et al., OPTICS EXPRESS, Vol. 19, No. 15, 2011, S. 1473 bis 1475 und der Fachartikel "Highly efficient three-level blazed grating in the resonance domain" von M. Oliva et al., OPTICS LETTERS Vol. 35, No. 16, 2010, S. 2774 bis 2776 beschreiben verschiedene Varianten von Blaze-Gittern. Aus dem Fachartikel "Diffractive elements designed to suppress unwanted zeroth order due to surface depth error" von V. Kettunen et al., Journal of Modern Optics 51, 14, 2111-2123, 2004 sind diffraktive Elemente zur Unterdrückung unerwünschter nullter Beugungsordnungen aufgrund eines Profiltiefenfehlers bekannt. Die US 9,551,941 B2 offenbart ein Beleuchtungssystem für eine EUV-Lithografieeinrichtung und einen Facettenspiegel hierfür. Die WO 96/13942 A1 offenbart ein Beleuchtungssystem für Display-Panele. Die US 5,162,943 offenbart eine Bildleseeinrichtung mit einem Beugungsgitter. Die US 2009/0289205 A1 offenbart einen Spiegel für ein EUV-Herstellungsverfahren in Form eines EUV-Kollektorspiegels. Die DE 10 2018 218 981 A1 offenbart ein optisches Gitter für einen EUV-Kollektor einer Projektionsbelichtungsanlage.

Ein optisches Gitter kann zur Unterdrückung von Falschlicht einer von Nutzlicht abweichenden Wellenlänge genutzt werden. Das Falschlicht kann dann vom optischen Gitter hin zu einer Lichtfalle (beam dump) gebeugt werden, wohingegen Nutzlicht einen anderen Weg nimmt.

Es ist eine Aufgabe der vorliegenden Erfindung, eine optische Beugungskomponente der eingangs genannten Art derart weiterzubilden, dass deren Einsatzmöglichkeiten insbesondere zur Falschlicht-Unterdrückung erweitert sind.

Diese Aufgabe ist erfindungsgemäß gelöst durch eine optische Beugungskomponente mit den im Anspruch 1 angegebenen Merkmalen. Erfindungsgemäß wurde erkannt, dass bei einer drei-Niveau Struktur ein Erstreckungsverhältnis zwischen einer Erstreckung eines Neutral-Beugungsstruktur-Niveaus und einer Gesamterstreckung einer Gitterperiode einen Freiheitsgrad darstellt, der gezielt dazu genutzt werden kann, eine Unterdrückung unterschiedlicher Ziel-Wellenlängen innerhalb vorgegebener Unterdrückungsanforderungen zu erreichen. Vergleichsweise geringe Anpassungen im Vergleich zu Anordnungen von Beugungsstruktur-Niveaus, bei denen ein Neutral-Beugungsstruktur-Niveau innerhalb einer Gitterperiode exakt 50 % der Erstreckung der Gitterperiode aufweist, führen dabei überraschend zur Möglichkeit, unterschiedliche Ziel-Wellenlängen mit sich vergleichsweise gering unterscheidenden Wellenlängen zu unterdrücken.

Zur Erfüllung der Bedingung der destruktiven Interferenz der drei Strahlungsanteile mit verschiedenen Phasen kann die Strukturtiefe $d_0$, um die das Positiv-Beugungsstruktur-Niveau gegenüber dem Neutral-Beugungsstruktur-Niveau erhaben ist bzw. um die das Negativ-Beugungsstruktur-Niveau gegenüber dem Neutral-Beugungsstruktur-Niveau abgesenkt ist, im Bereich von einem Viertel der gemittelten Ziel-Wellenlänge ($\lambda/4$) liegen. Abhängig von den beiden Ziel-Wellenlängen werden die Erstreckungen der Beugungsstruktur-Niveaus sowie die Strukturtiefe so gewählt, dass sich für die drei verschiedenen Phasen bei beiden Wellenlängen eine Unterdrückung ergibt. Eine Erstreckung des Neutral-Beugungsstruktur-Niveaus innerhalb der Gitterperiode kann kleiner sein als 49,95 % der Erstreckung der Gitterperiode, kann kleiner sein als 49 %, kann kleiner sein als 45 %, kann kleiner sein als 40 %, kann kleiner sein als 35 %, kann kleiner sein als 30 %, kann kleiner sein als 25 %, kann kleiner sein als 20 % und kann auch kleiner sein als 15 % der Erstreckung der Gitterperiode. Die Erstreckung des Neutral-Beugungsstruktur-Niveaus innerhalb der Gitterperiode kann größer sein als 5 % der Erstreckung der Gitterperiode.

Der Unterschied zwischen den beiden sich vergleichsweise gering unterscheidenden Ziel-Wellenlängen ist kleiner als 50 %. Wenn die erste, größere Ziel-Wellenlänge mit $\lambda 1$ und die zweite, kleinere Ziel-Wellenlänge mit $\lambda 2$ bezeichnet ist, ist $\lambda 1 - \lambda 2$ also kleiner als $0,5 \lambda 1$.

Ein zum Gegenstand des Anspruchs 1 alternatives und dementsprechend nicht erfindungsgemäßes Unterschieds-Kriterium zwischen den beiden sich vergleichsweise gering unterscheidenden Ziel-Wellenlängen $\lambda 1$ und $\lambda 2$, das

anstelle des vorstehend diskutierten, erfindungsgemäßen Kriteriums "Unterschied der beiden Ziel-Wellenlängen kleiner als 50 %" treten kann, ist

$$(\lambda 1 - \lambda 2)^2 / (\lambda 1 + \lambda 2)^2 < 20 \text{ %}.$$

Hierbei kann gelten: $(\lambda 1 - \lambda 2)^2 / (\lambda 1 + \lambda 2)^2 < 15$ %, < 12 %, < 10 %, < 8 %, < 5 %, < 4 %, < 3 %, < 2 % oder auch < 1 %. Bei einer zum Gegenstand des Anspruchs 1 alternativen und dementsprechend nicht erfindungsgemäßen Ausführung der optischen Beugungskomponente, die zur Unterdrückung zweier sich stärker unterscheidenden Wellenlängen ausgeführt ist, gilt, dass der Unterschied zwischen den beiden sich stärker unterscheidenden Ziel-Wellenlängen größer ist als 50 %. Es gilt dann, dass $\lambda 1 - \lambda 2$ größer ist als 0,5 $\lambda 1$.

Dieser Unterschied kann größer sein als 60 %, kann größer sein als 70 % und kann größer sein als 80 %.

Dieses nicht erfindungsgemäße Kriterium hinsichtlich der Unterdrückung zweier sich stärker unterscheidender Wellenlängen kann auch, analog zum vorstehend diskutierten Kriterium "sich vergleichsweise gering unterscheidende Wellenlängen", wie folgt ausgedrückt werden:

$$(\lambda 1 - \lambda 2)^2 / (\lambda 1 + \lambda 2)^2 > 20 \text{ %}.$$

Dieser Unterschied $((\lambda 1 - \lambda 2)^2 / (\lambda 1 + \lambda 2)^2$ kann noch größer sein und kann größer sein als 30 %, kann größer sein als 50 % und kann auch größer sein als 80 %.

Die optische Beugungskomponente kann auch zur Unterdrückung von drei unterschiedlichen Ziel-Wellenlängen ausgelegt sein, von denen zwei unterschiedliche Ziel-Wellenlängen das obige erfindungsgemäße Kriterium "vergleichsweise geringer Unterschied" erfüllen. Es ist möglich, dass zwei der drei zu unterdrückenden Ziel-Wellenlängen das erfindungsgemäße Kriterium "vergleichsweise geringer Unterschied" und zwei andere der drei zu unterdrückenden Ziel-Wellenlängen das andere Kriterium "stärkerer Unterschied" erfüllen.

Die beiden Ziel-Wellenlängen oder zwei der drei Ziel-Wellenlängen können beispielsweise 10,2 $\mu$m und 10,6 $\mu$m und/oder 10,6 $\mu$m und 1,046 $\mu$m betragen.

Gleiche Erstreckungen des Positiv-Beugungsstruktur-Niveaus einerseits und des Negativ-Beugungsstruktur-Niveaus andererseits innerhalb der Gitterperiode nach Anspruch 2 führen zu einem guten Unterdrückungsergebnis für beide Ziel-Wellenlängen.

Entsprechendes gilt für gleiche absolute Strukturtiefen nach Anspruch 3. Strahlungen zweier unterschiedlicher Ziel-Wellenlängen nach den Ansprüchen 4 und 5 lassen sich gemeinsam mit der optischen Beugungskomponente unterdrücken. Der Unterschied kann größer sein als 5 %, kann größer sein als 10 %, kann größer als 15 %, kann größer sein als 20 %, kann größer sein als 25 %, kann größer sein als 30 %, kann größer sein als 35 %, kann größer sein als 40 %, kann größer sein als 45 %. Der Unterschied der beiden Ziel-Wellenlängen ist kleiner als 50 % und kann auch kleiner sein als 10 %. Die beiden Ziel-Wellenlängen können beispielsweise innerhalb eines Wellenlängenbandes zwischen 1 $\mu$m und 10,1 $\mu$m liegen.

Eine Gitterperiodenerstreckung nach Anspruch 6 vereinfacht eine Herstellung der optischen Beugungskomponente.

Eine spiegelsymmetrische Anordnung der Beugungsstruktur-Niveaus nach Anspruch 7 führt ebenfalls zu einer Vereinfachung der Herstellung.

Die Vorteile eines EUV-Kollektors nach Anspruch 8 entsprechen denen, die vorstehend unter Bezugnahme auf die optische Beugungskomponente bereits erläutert wurden. Insbesondere beim Einsatz im Zusammenhang mit einer EUV-Lichtquelle, bei der Plasma durch laserinduzierte Entladung erzeugt wird, sind diese Vorteile evident.

Die Strahlung der beiden Ziel-Wellenlängen wird auch als Falschlicht bezeichnet.

Die Vorteile eines Beleuchtungssystems nach Anspruch 9 entsprechen denjenigen, die vorstehend unter Bezugnahme auf den erfindungsgemäßen EUV-Kollektors bereits erläutert wurden. Das EUV-Nutzlicht wird von der optischen Beugungskomponente gerade nicht unterdrückt, hat also eine andere Wellenlänge als zu unterdrückendes Falschlicht.

Das Beleuchtungssystem kann mit der wie oben beschrieben ausgeführten optischen Beugungskomponente so gestaltet sein, dass eine homogene Verteilung des Falschlichtes im Bereich von Falschlicht-Abführorten und beispielsweise im Bereich von hierfür vorgesehenen Beam dumps erfolgt. Alternativ oder zusätzlich kann eine vorgegebene Verteilungsfunktion des Nutzlichts insbesondere in spezifischen Abschnitten eines Beleuchtungs-Strahlengangs des Beleuchtungssystems, beispielsweise im Bereich einer Pupillenebene, gewährleistet sein.

Die Vorteile eines optischen Systems nach Anspruch 11, einer Projektionsbelichtungsanlage nach Anspruch 12 und eines Herstellungsverfahrens nach Anspruch 13 entsprechen denen, die vorstehend unter Bezugnahme auf den erfindungsgemäßen Kollektor bereits erläutert wurden.

Hergestellt werden kann mit der Projektionsbelichtungsanlage insbesondere ein Halbleiter-Bauteil, beispielsweise ein Speicherchip oder ein Chip zur Datenverarbeitung.

Ausführungsbeispiele der Erfindung werden nachfolgend anhand der Zeichnung näher erläutert. In dieser zeigen:

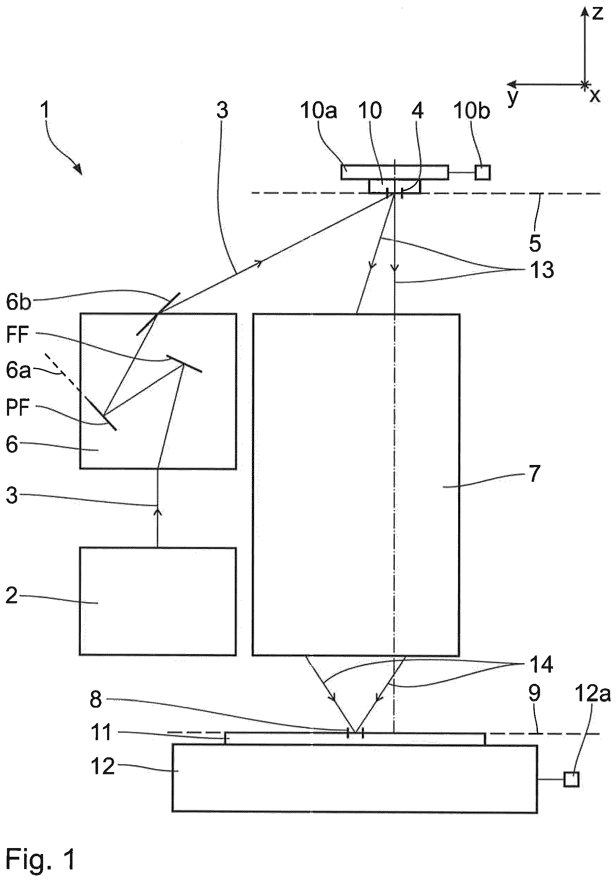

Fig. 1    schematisch eine Projektionsbelichtungsanlage für die EUV-Mikrolithographie;

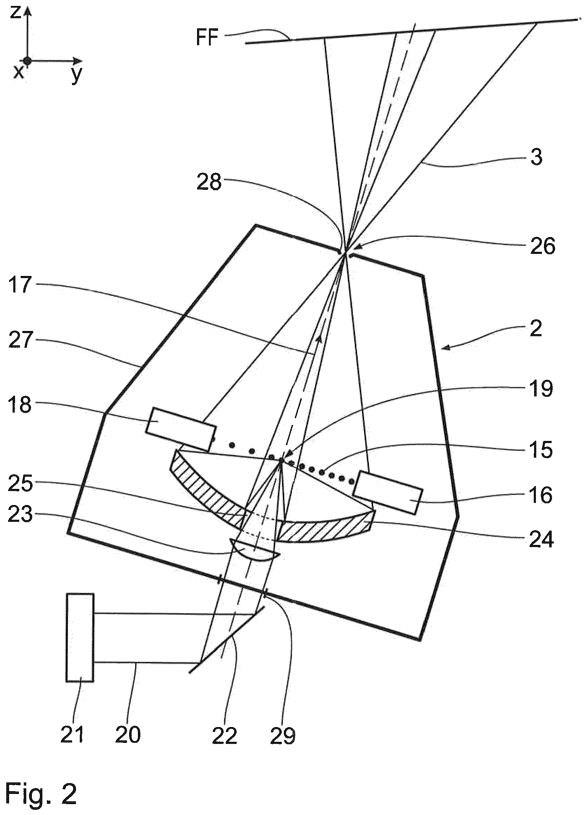

Fig. 2    Details einer Lichtquelle der Projektionsbelichtungsanlage im Umfeld eines EUV-Kollektors zur Führung von EUV-Nutzlicht von einem Plasma-Quellbereich hin zu einem Feldfacettenspiegel einer Beleuchtungsoptik der Projektionsbelichtungsanlage, wobei der EUV-Kollektor in einem Meridionalschnitt dargestellt ist;

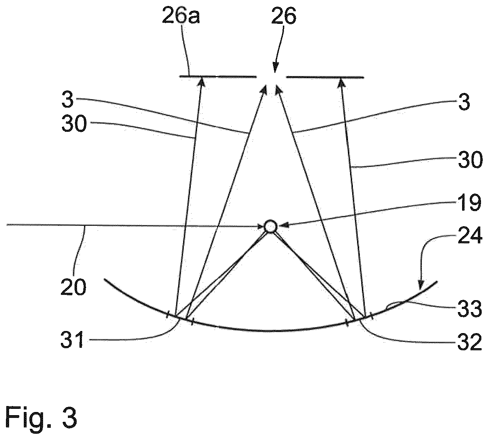

Fig. 3    in einer im Vergleich zur Fig. 3 abstrakteren Darstellung eine Führung einerseits von EUV-Nutzlicht und andererseits von wellenlängenverschiedenen Falschlicht-Anteilen bei einer Reflexion/Beugung am EUV-Kollektor;

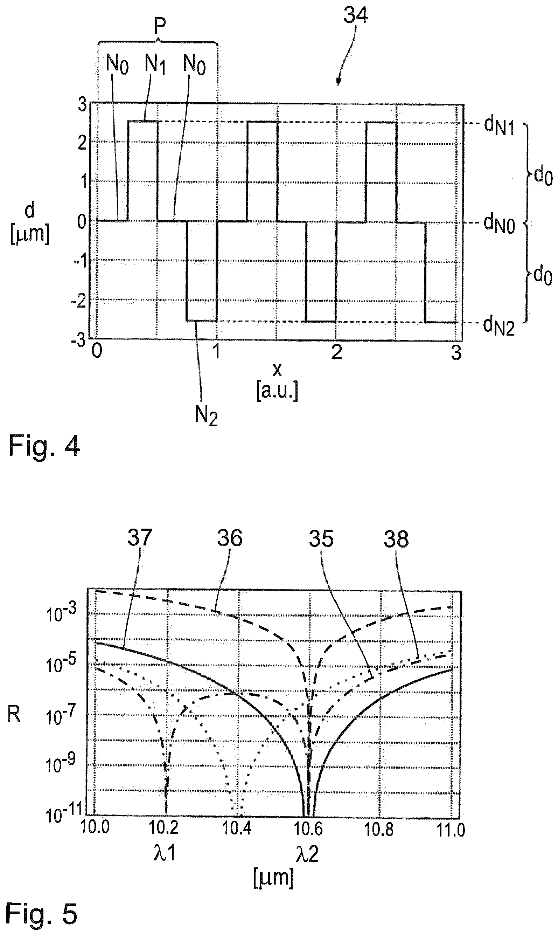

Fig. 4    in einer in Bezug auf eine Strukturtiefe stark vergrößerten Darstellung eine Seitenansicht einer optischen Beugungskomponente mit einem periodischem Gitter-Strukturprofil mit Beugungsstrukturen mit genau drei Beugungsstruktur-Niveaus, wobei innerhalb einer Gitterperiode ein Neutral-Beugungsstruktur-Niveau eine Erstreckung längs einer Perioden-Laufrichtung aufweist, die kleiner ist als 50 % der Erstreckung der Gitterperiode längs der Perioden-Laufrichtung;

Fig. 5    in einem Diagramm eine wellenlängenabhängige Reflektivität der Beugungskomponente nach Fig. 4 (strichpunktiert) im Vergleich zu anderen, nicht erfindungsgemäßen optischen Beugungskomponenten;

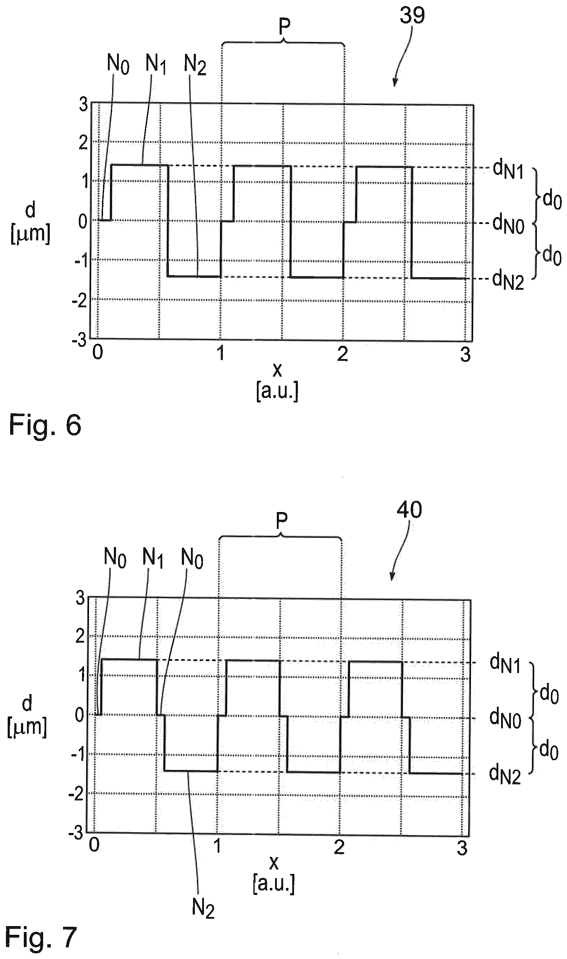

Fig. 6    in einer zu Fig. 4 ähnlichen Darstellung eine weitere nicht erfindungsgemäße Ausführung einer optischen Beugungskomponente, wiederum mit drei Beugungsstruktur-Niveaus, ausgeführt zur Unterdrückung einer ersten Ziel-Wellenlänge im Bereich von 10 µm und einer zweiten Ziel-Wellenlänge im Bereich von 1 µm, mit einem ersten, asymmetrischen Layout der Beugungsstruktur-Niveaus;

Fig. 7    in einer zu Fig. 4 ähnlichen Darstellung eine nicht erfindungsgemäße Ausführung der optischen Beugungskomponente, die abgesehen davon, dass ein symmetrisches Layout der Beugungsstruktur-Niveaus vorliegt, derjenigen nach Fig. 6 entspricht;

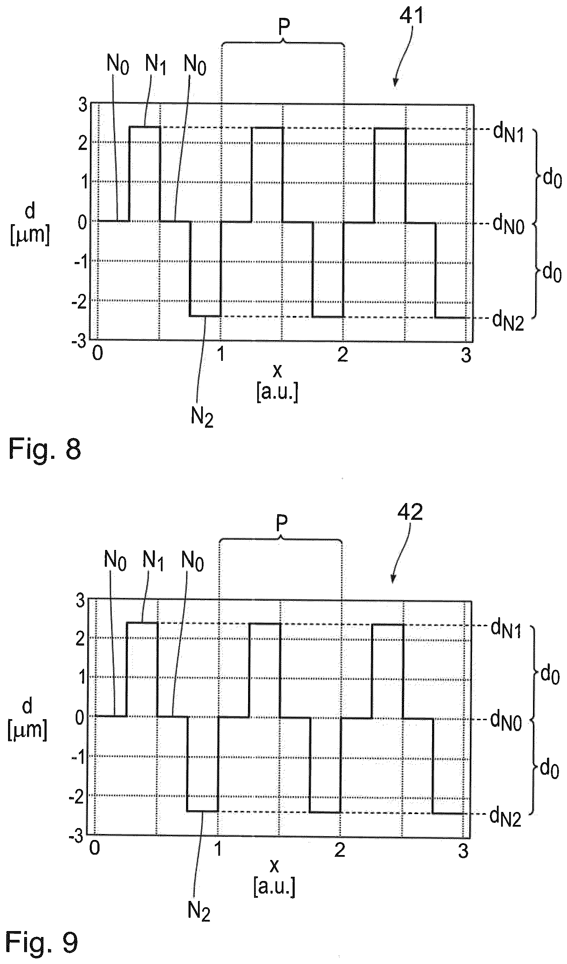

Fig. 8    in einer zu Fig. 4 ähnlichen Darstellung eine weitere nicht erfindungsgemäße Ausführung einer optischen Beugungskomponente mit drei Beugungsstruktur-Niveaus, wiederum gestaltet zur Unterdrückung einer ersten Ziel-Wellenlänge im Bereich von 10 µm und einer zweiten Ziel-Wellenlänge im Bereich von 1 µm;

Fig. 9    in einer zu Fig. 4 ähnlichen Darstellung eine weitere nicht erfindungsgemäße Ausführung einer optischen Beugungskomponente mit drei Beugungsstruktur-Niveaus, wiederum gestaltet zur Unterdrückung einer ersten Ziel-Wellenlänge im Bereich von 10 µm und einer zweiten Ziel-Wellenlänge im Bereich von 1 µm;

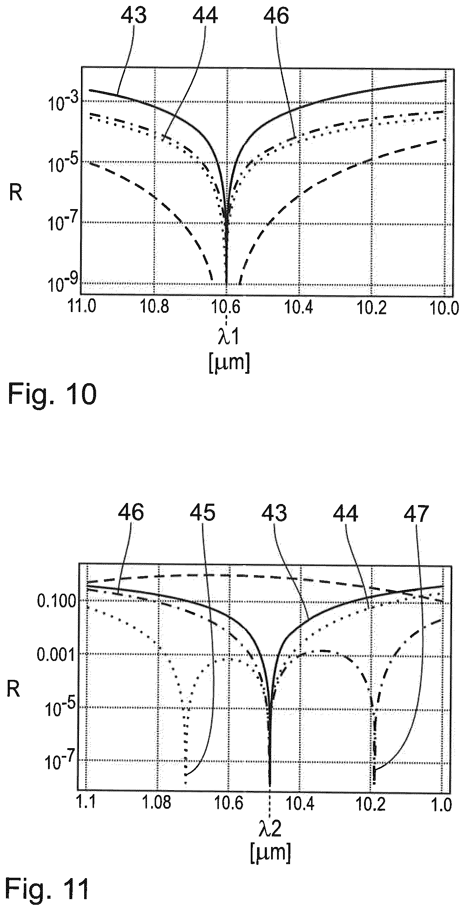

Fig. 10   in einer zu Fig. 5 ähnlichen Darstellung eine wellenlängenabhängige Reflektivität R im Bereich der ersten Ziel-Wellenlänge für die optischen Beugungskomponenten nach den Fig. 6 und 7 (durchgezogen), nach Fig. 8 (gepunktet) und nach Fig. 9 (strichpunktiert) im Vergleich zu einer nicht erfindungsgemäßen optischen Beugungskomponente (gestrichelt);

Fig. 11   in einer zu Fig. 10 ähnlichen Darstellung die wellenlängenabhängige Reflektivität der optischen Beugungskomponenten nach den Fig. 6/7, 8 und 9 im Vergleich zur nicht erfindungsgemäßen optischen Beugungskomponente im Bereich der zweiten Ziel-Wellenlänge.

Eine Projektionsbelichtungsanlage 1 für die Mikrolithographie hat eine Lichtquelle 2 für Beleuchtungslicht bzw. Abbildungslicht 3, die nachfolgend noch weiter erläutert wird. Bei der Lichtquelle 2 handelt es sich um eine EUV-Lichtquelle, die Licht in einem Wellenlängenbereich beispielsweise zwischen 5 nm und 30 nm, insbesondere zwischen 5 nm und 15 nm, erzeugt. Das Beleuchtungs- bzw. Abbildungslicht 3 wird nachfolgend auch als EUV-Nutzlicht bezeichnet.

Bei der Lichtquelle 2 kann es sich insbesondere um eine Lichtquelle mit einer Wellenlänge von 13,5 nm oder um eine Lichtquelle mit einer Wellenlänge von 6,9 nm handeln. Auch andere EUV-Wellenlängen sind möglich. Ein Strahlengang des Beleuchtungslichts 3 ist in der Fig. 1 äußerst schematisch dargestellt.

Zur Führung des Beleuchtungslichts 3 von der Lichtquelle 2 hin zu einem Objektfeld 4 in einer Objektebene 5 dient eine Beleuchtungsoptik 6. Letztere umfasst einen in der Fig. 1 stark schematisch dargestellten Feldfacettenspiegel FF und einen im Strahlengang des Beleuchtungslichts 3 nachfolgenden, ebenfalls stark schematische dargestellten Pupillenfacettenspiegel PF. Zwischen dem Pupillenfacettenspiegel PF, der in einer Pupillenebene 6a der Beleuchtungsoptik angeordnet ist, und dem Objektfeld 4 ist ein feldformender Spiegel 6b für streifenden Einfall (GI-Spiegel, grazing incidence Spiegel) im Strahlengang des Beleuchtungslichts 3 angeordnet. Ein derartiger GI-Spiegel 6b ist nicht zwingend.

Nicht näher dargestellte Pupillenfacetten des Pupillenfacettenspiegels PF sind Teil einer Übertragungsoptik, die ebenfalls nicht dargestellte Feldfacetten des Feldfacettenspiegels FF einander überlagernd in das Objektfeld 4 überführen und insbesondere abbilden. Für den Feldfacettenspiegel FF einerseits und den Pupillenfacettenspiegel PF andererseits kann eine Ausführung genutzt werden, die aus dem Stand der Technik bekannt ist. Eine derartige Beleuchtungsoptik ist beispielsweise bekannt aus der DE 10 2009 045 096 A1.

Mit einer Projektionsoptik bzw. abbildenden Optik 7 wird das Objektfeld 4 in ein Bildfeld 8 in einer Bildebene 9 mit einem vorgegebenen Verkleinerungsmaßstab abgebildet. Hierfür einsetzbare Projektionsoptiken sind beispielweise bekannt aus der DE 10 2012 202 675 A1.

Zur Erleichterung der Beschreibung der Projektionsbelichtungsanlage 1 sowie der verschiedenen Ausführungen der Projektionsoptik 7 ist in der Zeichnung ein kartesisches xyz-Koordinatensystem angegeben, aus dem sich die jeweilige Lagebeziehung der in den Figuren dargestellten Komponenten ergibt. In der Fig. 1 verläuft die x-Richtung senkrecht zur Zeichenebene in diese hinein. Die y-Richtung verläuft in der Fig. 1 nach links und die z-Richtung in der Fig. 1 nach oben. Die Objektebene 5 verläuft parallel zur xy-Ebene.

Das Objektfeld 4 und das Bildfeld 8 sind rechteckförmig. Alternativ ist es auch möglich, das Objektfeld 4 und Bildfeld 8 gebogen bzw. gekrümmt, also insbesondere teilringförmig auszuführen. Das Objektfeld 4 und das Bildfeld 8 haben ein xy-Aspektverhältnis größer als 1. Das Objektfeld 4 hat also eine längere Objektfelddimension in der x-Richtung und eine kürzere Objektfelddimension in der y-Richtung. Diese Objektfelddimensionen verlaufen längs der Feldkoordinaten x und y.

Für die Projektionsoptik 7 kann eines der aus dem Stand der Technik bekannten Ausführungsbeispiele eingesetzt werden. Abgebildet wird hierbei ein mit dem Objektfeld 4 zusammenfallender Ausschnitt einer Reflexionsmaske 10, die auch als Retikel bezeichnet wird. Das Retikel 10 wird von einem Retikelhalter 10a getragen. Der Retikelhalter 10a wird von einem Retikelverlagerungsantrieb 10b verlagert.

Die Abbildung durch die Projektionsoptik 7 erfolgt auf die Oberfläche eines Substrats 11 in Form eines Wafers, der von einem Substrathalter 12 getragen wird. Der Substrathalter 12 wird von einem Wafer- bzw. Substratverlagerungsantrieb 12a verlagert.

In der Fig. 1 ist schematisch zwischen dem Retikel 10 und der Projektionsoptik 7 ein in diese einlaufendes Strahlenbündel 13 des Beleuchtungslichts 3 und zwischen der Projektionsoptik 7 und dem Substrat 11 ein aus der Projektionsoptik 7 auslaufendes Strahlenbündel 14 des Beleuchtungslichts 3 dargestellt. Eine bildfeldseitige numerische Apertur (NA) der Projektionsoptik 7 ist in der Fig. 1 nicht maßstäblich wiedergegeben.

Die Projektionsbelichtungsanlage 1 ist vom Scannertyp. Sowohl das Retikel 10 als auch das Substrat 11 werden beim Betrieb der Projektionsbelichtungsanlage 1 in der y-Richtung gescannt. Auch ein Steppertyp der Projektionsbelichtungsanlage 1, bei dem zwischen einzelnen Belichtungen des Substrats 11 eine schrittweise Verlagerung des Retikels 10 und des Substrats 11 in der y-Richtung erfolgt, ist möglich. Diese Verlagerungen erfolgen synchronisiert zueinander durch entsprechende Ansteuerung der Verlagerungsantriebe 10b und 12a.

Fig. 2 zeigt Details der Lichtquelle 2.

Bei der Lichtquelle 2 handelt es sich um eine LPP-Quelle (laser produced plasma, lasererzeugtes Plasma). Zur Plasmaerzeugung werden Zinn-Tröpfchen 15 von einem Zinn-Tröpfchengenerator 16 als kontinuierliche Tröpfchenabfolge erzeugt. Eine Flugbahn der Zinn-Tröpfchen 15 verläuft quer zu einer Hauptstrahlrichtung 17 des EUV-Nutzlichts 3. Die Zinn-Tröpfchen 15 fliegen dabei frei zwischen dem Zinn-Tröpfchengenerator 16 und einem Zinn-Fänger 18, wobei sie einen Plasma-Quellbereich 19 durchtreten. Vom Plasma-Quellbereich 19 wird das EUV-Nutzlicht 3 emittiert. Im Plasma-Quellbereich 19 wird das dort ankommende Zinn-Tröpfchen 15 mit Pumplicht 20 einer Pumplichtquelle 21 beaufschlagt. Bei der Pumplichtquelle 21 kann es sich um eine Infrarot-Laserquelle in Form beispielsweise eines $CO_2$-Lasers handeln. Auch eine andere IR-Laserquelle ist möglich, insbesondere ein Festkörperlaser, beispielsweise ein Nd:YAG-Laser. Die Pumplichtquelle 21 kann eine Lichtquelleneinheit zur Erzeugung eines Vor-Lichtimpulses und eine Lichtquelleneinheit zur Erzeugung eines Haupt-Lichtimpulses aufweisen. Der Vor-Lichtimpuls einerseits und der Haupt-Lichtimpuls andererseits können verschiedene Lichtwellenlängen aufweisen.

Das Pumplicht 20 wird über einen Spiegel 22, bei dem es sich um einen geregelt verkippbaren Spiegel handeln kann, und über eine Fokussierlinse 23 in den Plasma-Quellbereich 19 überführt. Durch die Pumplichtbeaufschlagung wird aus dem im Plasma-Quellbereich 19 ankommenden Zinn-Tröpfchen 15 ein das EUV-Nutzlicht 3 emittierendes Plasma erzeugt. Ein Strahlengang des EUV-Nutzlichts 3 ist in der Fig. 2 zwischen dem Plasma-Quellbereich 19 und dem Feldfacettenspiegel FF dargestellt, soweit das EUV-Nutzlicht von einem Kollektorspiegel 24 reflektiert wird, der nachfolgend auch als EUV-Kollektor 24 bezeichnet ist. Der EUV-Kollektor 24 hat eine zentrale Durchtrittsöffnung 25 für das über die Fokussierlinse 23 hin zum Plasma-Quellbereich 19 fokussierte Pumplicht 20. Der Kollektor 24 ist als Ellipsoidspiegel ausgeführt und überführt das vom Plasma-Quellbereich 19, der in einem Ellipsoidbrennpunkt angeordnet ist, emittierte EUV-Nutzlicht 3 in einen Zwischenfokus 26 des EUV-Nutzlichts 3, der im anderen Ellipsoidbrennpunkt des Kollektors 24 angeordnet ist.

Der Feldfacettenspiegel FF ist im Strahlengang des EUV-Nutzlichts 3 nach dem Zwischenfokus 26 im Bereich eines Fernfeldes des EUV-Nutzlichts 3 angeordnet.

Der EUV-Kollektor 24 und weitere Komponenten der Lichtquelle 2, bei denen es sich um den Zinn-Tröpfchengenerator 16, den Zinn-Fänger 18 und um die Fokussierlinse 23 handeln kann, sind in einem Vakuumgehäuse 27 angeordnet. Im Bereich des Zwischenfokus 26 hat das Vakuumgehäuse 27 eine Durchtrittsöffnung 28. Im Bereich eines Eintritts des Pumplichts 20 in das Vakuumgehäuse 27 hat letzteres ein Pumplicht-Eintrittsfenster 29 für den Vor-Lichtimpuls und für den Haupt-Lichtimpuls.

Fig. 3 zeigt stark abstrakt eine Führung einerseits von EUV-Nutzlicht, also dem Beleuchtungslicht 3 und andererseits von Falschlicht 30, insbesondere von längerwelliger Strahlung, beispielsweise IR-Strahlung mit den Wellenlängen des Vor-Lichtimpulses und/oder des Haupt-Lichtimpulses, zwischen dem Plasma-Quellbereich 19 der Lichtquelle 2 und einer Zwischenfokusebene 26a, in der der Zwischenfokus 26 angeordnet ist. Gleichzeitig zeigt die Fig. 3 eine Variante einer seitlichen Führung des Pumplichts 20 hin zum Plasma-Quellbereich 19, also eine Führung, bei der es einer Durchtrittsöffnung nach Art der Durchtrittsöffnung 25 im EUV-Kollektor 24 nicht bedarf. Sowohl das Nutzlicht 3 als auch das Falschlicht 30 gehen vom Plasma-Quellbereich 19 aus. Sowohl das Nutzlicht 3 als auch das Falschlicht 30 treffen auf Flächenabschnitte 31, 32 einer gesamten Beaufschlagungsfläche 33 des EUV-Kollektors 24. Die Flächenabschnitte 31, 32 sind Abschnitte einer in der Zeichnung ebenfalls mit 33 bezeichneten Gitterfläche des EUV-Kollektors 24, auf der ein optisches Gitter zum beugenden Abführen der Falschlicht-Strahlung 30 angeordnet ist. Ausführungen für das optische Gitter werden nachfolgend beschrieben. Die Gitterfläche kann ausschließlich am Ort der vom Falschlicht 30 beaufschlagten Flächenabschnitte 31, 32 angeordnet sein oder kann alternativ auch größere Abschnitte der Beaufschlagungsfläche 33 bedecken und bei einer weiteren Variante die gesamte Beaufschlagungsfläche 33 überdecken.

Fig. 4 zeigt eine Ausführung einer optischen Beugungskomponente 34 zur Unterdrückung zweier unterschiedlicher Ziel-Wellenlängen, nämlich der Wellenlängen des Vor-Lichtimpulses der Lichtquelle 2 einerseits und des Haupt-Lichtimpulses der Lichtquelle 2 andererseits. Die optische Beugungskomponente 34 ist als optisches Gitter mit einer Gitterperiode P längs einer Perioden-Laufrichtung x ausgeführt. Dargestellt ist in der Fig. 4 eine Strukturhöhe d des optischen Gitters 34 aufgetragen über die Perioden-Laufrichtung x. Die Strukturtiefe d ist mit einer im Vergleich zur Perioden-Laufrichtung x stark vergrößerten Skalierung dargestellt. Eine typische Größenordnung für die Strukturtiefe d sind wenige Mikrometer. Eine typische Größenordnung für die Periode P liegt im Millimeter-Bereich, beispielsweise im Bereich zwischen 0,5 und 10 mm, beispielsweise im Bereich zwischen 1 mm und 4 mm.

Nachfolgend sind Strukturtiefen-Werte d teilweise mit gerechneter Genauigkeit angegeben, wobei es regelmäßig genügt, die Strukturtiefe bei einer Angabe in Mikrometer auf zwei Stellen nach dem Komma zu runden.

Das Gitter-Strukturprofil der optischen Beugungskomponente 34 hat Beugungsstrukturen mit genau drei Beugungsstruktur-Niveaus, die in der Fig. 4 mit $N_0$, $N_1$ und $N_2$ bezeichnet sind. Die Beugungsstruktur-Niveaus $N_0$ bis $N_2$ geben unterschiedliche Strukturtiefen $d_{Ni}$ relativ zu einer Referenzebene (d = 0) vor. Das Beugungsstruktur-Niveau $N_1$ ist ein Positiv-Beugungsstruktur-Niveau mit einer Strukturtiefe (Strukturhöhe) $d_{N1} = d_0$ von 2,59904 $\mu$m (bzw. 2,60 $\mu$m). Das Beugungsstruktur-Niveau $N_0$ ist als Neutral-Beugungsstruktur-Niveau mit einer Strukturtiefe $d_{N0}$ von 0 ausgeführt. Das Beugungsstruktur-Niveau $N_0$ liegt also auf Höhe der Referenzebene. Das Beugungsstruktur-Niveau $N_2$ ist als Negativ-Beugungsstruktur-Niveau ausgeführt und gegenüber dem Neutral-Beugungsstruktur-Niveau $N_0$ um eine Struk-turtiefe $d_{N2} = -d_0$ von absolut 2,59904 $\mu$m abgesenkt. Für die Strukturtiefe des Negativ-Beugungsstruktur-Niveaus $N_2$ gilt also: $d_{N2}$ = -2,59904 $\mu$m.

Die Beugungsstrukturen des optischen Gitters 34 sind so angeordnet, dass ein Wellenlängenbereich um die beiden Ziel-Wellenlängen λ1, z. B. des Vor-Lichtimpulses, und λ2, z. B. des Haupt-Lichtimpulses, die von dem Gitter-Strukturprofil gebeugt werden, Strahlenanteile mit drei verschiedenen Phasen aufweist, die miteinander destruktiv interferieren.

Die Beugungsstruktur-Niveaus $N_0$ bis $N_2$ geben eine Topografie einer sich längs der Perioden-Laufrichtung x regelmäßig wiederholenden Gitterperiode des Gitter-Strukturprofils vor.

Bei der dargestellten Ausführung nach Fig. 4 liegt folgende Abfolge der verschiedenen Beugungsstruktur-Niveaus $N_i$ innerhalb der Gitterperiode vor: $N_0$, $N_1$, $N_0$, $N_2$. Auch eine zyklische Vertauschung oder eine Spiegelung dieser Abfolge ist möglich.

Innerhalb der Gitterperiode P hat das Neutral-Beugungsstruktur-Niveau $N_0$ eine Gesamterstreckung $a_0$ längs der Perioden-Laufrichtung x, die kleiner ist als 50 % der Erstreckung der gesamten Gitterperiode P. Eine Summe der Erstreckungen $a_1$, $a_2$ des Positiv-Beugungsstruktur-Niveaus $N_1$ und des Negativ-Beugungsstruktur-Niveaus $N_2$ ist also größer als die Gesamterstreckung des Neutral-Beugungsstruktur-Niveaus $N_0$.

Das optische Gitter 34 ist in der Fig. 4 mit ideal steilen Flanken zwischen den verschiedenen Beugungsstruktur-Niveaus $N_i$ dargestellt.

Auch eine die jeweilige Erstreckung $a_0$, $a_1$, $a_2$ der verschiedenen Beugungsstruktur-Niveaus $N_i$ innerhalb der Gitterperiode P erhaltende Verschiebung der Beugungsstruktur-Niveaus $N_i$ ist möglich. So kann beispielsweise das

Positiv-Beugungsstruktur-Niveau $N_1$ anders als bei der in der Fig. 4 dargestellten symmetrischen Anordnung zwischen zwei gleichweit längs der Perioden-Laufrichtung x erstreckten Neutral-Beugungsstruktur-Niveaus $N_0$ asymmetrisch angeordnet sein, sodass die Neutral-Beugungsstruktur-Niveaus in der Perioden-Laufrichtung x vor und nach dem Positiv-Beugungsstruktur-Niveau $N_1$ eine zueinander verschiedene Erstreckung längs der Perioden-Laufrichtung haben. Es ist auch möglich, anstelle von zwei voneinander getrennten Neutral-Beugungsstruktur-Niveaus $N_0$ innerhalb der Gitterperiode P genau ein Neutral-Beugungsstruktur-Niveau $N_0$ vorzusehen, dessen Erstreckung $a_0$ längs der Perioden-Laufrichtung x dann kleiner ist als 50 % der x-Erstreckung der Gitterperiode P.

Grundeigenschaften der optischen Beugungskomponente 34 sind nachfolgend tabelliert:

|  | Optisches Gitter 34 (Fig. 4) |
| --- | --- |
| a0 | 49,9543 % |
| a1(=a2) | 25,0228 % |
| $d_0$ | 2,59904 $\mu$m |
| $\lambda$1 | 10,2 $\mu$m |
| $\lambda$2 | 10,6 $\mu$m |

a0 bezeichnet hierbei das Verhältnis zwischen der Gesamterstreckung der Neutral-Beugungsstruktur-Niveaus $N_0$ in einer Gitterperiode P zur Erstreckung der Gitterperiode P.

a1(=a2) bezeichnen die Verhältnisanteile der Erstreckungen des Positiv-Beugungsstruktur-Niveaus $N_1$ und des Negativ-Beugungsstruktur-Niveaus $N_2$ innerhalb der Gitterperiode P relativ zur Gesamterstreckung der Gitterperiode P. Die Erstreckungen a1, a2 des Positiv-Beugungsstruktur-Niveaus N1 einerseits und des Negativ-Beugungsstruktur-Niveaus N2 andererseits längs der Perioden-Laufrichtung x sind genau gleich.

$d_0$ bezeichnet die absolute Strukturtiefe des Positiv-Beugungsstruktur-Niveaus $N_1$ einerseits und des Negativ-Beugungsstruktur-Niveaus $N_2$ andererseits.

$\lambda$ 1, $\lambda$2 bezeichnen die beiden zu unterdrückenden Ziel-Wellenlängen.

Die Erstreckungen $a_0$, $a_1$ und $a_2$ der Beugungsstruktur-Niveaus $N_0$, $N_1$, $N_2$ sowie die Strukturtiefe $d_0$ werden so gewählt, dass für beide Ziel-Wellenlängen $\lambda$1 und $\lambda$2 bei Addition der drei Strahlungsanteile mit verschiedenen Phasen, die bei Reflexion am Gitter-Strukturprofil aufgrund der Beugungsstruktur-Niveaus $N_i$ erzeugt werden, in Addition jeweils destruktive Interferenz resultiert. In einem Pfeildiagramm, bei dem Real- und Imaginärteil der Strahlungsanteile angegeben werden, summieren sich die drei Beiträge zu Null, wenn die Wellenlänge einer der beiden Zielwellenlängen entspricht.

Die Parameter $d_0$, $a_0$, $a_1$ und $a_2$ werden so ausgelegt, dass für beide Ziel-Wellenlängen $\lambda$1 und $\lambda$2 folgende Gleichung erfüllt ist:

$$a_0 + a_1 e^{+i4\pi d_0/\lambda} + a_2 e^{-i4\pi d_0/\lambda} = 0$$

Diese Gleichung gilt für den Fall, dass die Strahlung senkrecht auf das Gitter fällt. Eine Anpassung der Parameter für nicht-senkrechten Einfall ist für den Fachmann offensichtlich. Diese Anpassung kann über die Komponente hinweg variieren.

Fig. 5 zeigt in einem Diagramm wellenlängenabhängige Reflektivitäten R für verschiedene Gittervarianten im Wellenbereich zwischen 10,0 und 11,0 $\mu$m. Strichpunktiert dargestellt ist eine Reflektivität 35 der optischen Beugungskomponente 34. Bei den beiden Ziel-Wellenlängen $\lambda$ 1 und $\lambda$2 ergibt sich eine Unterdrückung von mehr als 10 Größenordnungen ($10^{-11}$).

Zum Vergleich sind in der Fig. 5 noch Reflektivitäten weiterer, nicht erfindungsgemäßer optischer Beugungskomponenten dargestellt, nämlich eines Binärgitters (Reflektivität 36), also eines Gitters mit genau zwei Beugungsstruktur-Niveaus mit gleichen Erstreckungen innerhalb einer Gitterperiode, eine Reflektivität 37 einer optischen Beugungskomponente mit drei Beugungsstruktur-Niveaus, wobei dort ein Neutral-Beugungsstruktur-Niveau exakt 50 % der Erstreckung der gesamten Gitterperiode hat mit einer Strukturtiefe von 2,65 $\mu$m und eine Reflektivität 38 einer entsprechenden optischen Beugungskomponente mit drei Beugungsstruktur-Niveaus, bei dem wiederum das Neutral-Beugungsstruktur-Niveau genau 50 % der Erstreckung der gesamten Gitterperiode hat, mit einer Strukturtiefe d = 2,60 $\mu$m. Die Reflektivität 36 zeigt eine schmalbandige Unterdrückung bei der Ziel-Wellenlänge $\lambda$2. Die Reflektivitäten 37 und 38 zeigen breitbandigere Unterdrückungen einerseits bei der Ziel-Wellenlänge $\lambda$2 (Reflektivität 37) und andererseits bei 10,4 $\mu$m (Reflektivität 38).

Fig. 6 bis 9 zeigen weitere nicht erfindungsgemäße Ausführungen optischer Beugungskomponenten.

Die Fig. 6 und 7 zeigen dabei zwei Ausführungen einer ersten Auslegung einer Erstreckungsverteilung der drei Beugungsstruktur-Niveaus des $N_0$, $N_1$, $N_2$, bei der das Neutral-Beugungsstruktur-Niveau eine im Vergleich zur Gesamterstreckung der Gitterperiode P vergleichsweise kleine Gesamterstreckung hat.

Fig. 6 zeigt dabei eine optische Beugungskomponente 39 mit einer asymmetrischen Auslegung der drei Beugungsstruktur-Niveaus $N_i$, bei der in der Perioden-Laufrichtung x auf das Neutral-Beugungsstruktur-Niveau $N_0$ zunächst das Positiv-Beugungsstruktur-Niveau $N_1$ und dann das Negativ-Beugungsstruktur-Niveau $N_2$ folgen.

Bei der Auslegung nach Fig. 6 liegt innerhalb einer Gitterperiode P also genau ein Neutral-Beugungsstruktur-Niveau $N_0$ vor.

Bei der optischen Beugungskomponente 40 nach Fig. 7 folgen in der Gitterperiode P die Beugungsstruktur-Niveaus $N_i$ folgendermaßen aufeinander: $N_0$, $N_1$, $N_0$, $N_2$. Von der Abfolge her entspricht dies also der Ausführung der optischen Beugungskomponente 34 nach Fig. 4.

Bei der Auslegung nach Fig. 7 liegt das Positiv-Beugungsstruktur-Niveau $N_1$ wiederum symmetrisch zwischen zwei gleichlang erstreckten Neutral-Beugungsstruktur-Niveaus $N_0$.

Optische Beugungskomponenten 41, 42 nach den Fig. 8 und 9 unterscheiden sich von der optischen Beugungskomponente 34 nach Fig. 4 nur in Parameterdetails.

Nachfolgend werden, entsprechend der obigen Tabellierung zur optischen Beugungskomponente 34 die Grundparameter der optischen Beugungskomponenten 39 bis 41 tabelliert:

| | Optisches Gitter 39/40 (Fig. 6/7) | Optisches Gitter 41 (Fig. 8) | Optisches Gitter 42 (Fig. 9) |
|---|---|---|---|
| a0 | 10,8652 % | 48,6984 % | 48,0496 % |
| a1(=a2) | 44,5674 % | 25,6508 % | 25,9752 % |
| $d_0$ | 1,42808 $\mu$m | 2,38013 $\mu$m | 2,32104 $\mu$m |

Die optischen Gitter 39 bis 42 nach den Fig. 6 bis 9 sind ausgelegt für eine Unterdrückung zweier stark unterschiedlicher Ziel-Wellenlängen $\lambda1$, $\lambda2$, nämlich einer ersten Ziel-Wellenlänge $\lambda1$ im Bereich von 10,6 $\mu$m und einer zweiten Ziel-Wellenlänge $\lambda2$ im Bereich von 1,046 $\mu$m.

Die Fig. 10 und 11 zeigen die Unterdrückungsleistung der optischen Beugungskomponenten 39 bis 42 wiederum im Vergleich zu einem nicht erfindungsgemäßen optischen Gitter mit drei Beugungsstruktur-Niveaus, die zur Unterdrückung genau einer Ziel-Wellenlänge, nämlich der Wellenlänge $\lambda1$ bei 10,6 $\mu$m ausgelegt ist.

Fig. 10 zeigt die Reflektivität R im Wellenlängenbereich zwischen 10 $\mu$m und 11 $\mu$m und die Fig. 11 zeigt die Reflektivität im Wellenlängenbereich zwischen 1,0 $\mu$m und 1,1 $\mu$m.

Die beiden Auslegungen, die zu den optischen Beugungskomponenten 39, 40 nach den Fig. 6 und 7 führen, ergeben die gleiche Unterdrückungswirkung, die in den Fig. 10 und 11 als Reflektivität 43 dargestellt ist. Sowohl bei der Ziel-Wellenlänge $\lambda1$ (Fig. 10) als auch bei der Ziel-Wellenlänge $\lambda2$ (Fig. 11) ergibt sich eine Unterdrückung, die besser ist als $10^{-7}$.

Eine Reflektivität 44 der optischen Beugungskomponente 41 hat eine ähnlich gute Unterdrückungswirkung bei den beiden Ziel-Wellenlängen, wobei bei dieser Auslegung der optischen Beugungskomponente 41 eine zusätzliche Unterdrückung im Bereich von 1,07 $\mu$m (Seitenminimum 45) stattfindet.

Auch die optische Beugungskomponente 42 hat eine Unterdrückung im Bereich der beiden Ziel-Wellenlängen $\lambda1$, $\lambda2$, die derjenigen der optischen Beugungskomponente 39, 40 vergleichbar ist (Reflektivität 46), wobei zusätzlich bei einer Wellenlänge von etwa 1,02 $\mu$m ein weiteres Seitenminimum 47 der Unterdrückung vorliegt.

Die Unterdrückung im Bereich der Ziel-Wellenlängen $\lambda1$, $\lambda2$ ist bei den optischen Beugungskomponenten 41, 42 etwas breitbandiger als bei den optischen Beugungskomponenten 39, 40.

Die vorstehend erläuterten Strukturierungen der optischen Gitter können bewirken, dass vom EUV-Kollektor 24 reflektierte Falschlicht-Strahlung beispielsweise mit infraroter Wellenlänge in einer nullten Ordnung destruktiv interferiert und somit eine Falschlicht-Intensität in der nullten Ordnung unterdrückt ist. Die vorstehend beschriebenen optischen Beugungskomponenten werden dabei im Regelfall als reflektierende Komponenten eingesetzt.

Ein Grundkörper des EUV-Kollektors 24 kann aus Aluminium gefertigt sein. Alternative Materialien für diesen Grundkörper sind Kupfer, Legierungen mit dem Bestandteil Kupfer und/oder Aluminium oder pulvermetallurgisch hergestellte Legierungen von Kupfer und Aluminiumoxid oder Silizium.

Zur Herstellung eines mikro- oder nanostrukturierten Bauteils wird die Projektionsbelichtungsanlage 1 folgendermaßen eingesetzt: Zunächst werden die Reflexionsmaske 10 bzw. das Retikel und das Substrat bzw. der Wafer 11 bereitgestellt. Anschließend wird eine Struktur auf dem Retikel 10 auf eine lichtempfindliche Schicht des Wafers 11 mithilfe der Projektionsbelichtungsanlage 1 projiziert. Durch Entwicklung der lichtempfindlichen Schicht wird dann eine Mikro- oder Nanostruktur auf dem Wafer 11 und somit das mikrostrukturierte Bauteil erzeugt.

**Patentansprüche**

1. Optische Beugungskomponente (34; 39; 40; 41; 42)

   - mit einem periodischen Gitter-Strukturprofil mit Beugungsstrukturen, aufweisend genau drei Beugungsstruktur-Niveaus ($N_0$, $N_1$, $N_2$), die unterschiedliche Strukturtiefen (d) relativ zu einer Referenzebene (d = 0) vorgeben,
   - wobei die Anordnung der Beugungsstrukturen derart ist, dass ein Wellenlängenbereich um zwei unterschiedliche Ziel-Wellenlängen $\lambda 1$, $\lambda 2$, die vom Gitter-Strukturprofil gebeugt werden, Strahlungsanteile mit drei verschiedenen Phasen aufweist, die miteinander destruktiv interferieren,
   - wobei die Beugungsstruktur-Niveaus ($N_0$, $N_1$, $N_2$) eine Topografie einer sich längs einer Perioden-Laufrichtung (x) regelmäßig wiederholenden Gitterperiode (P) des Gitterstrukturprofils vorgeben,
   - wobei die drei Beugungsstruktur-Niveaus ($N_0$, $N_1$, $N_2$) beinhalten:

      -- ein Neutral-Beugungsstruktur-Niveau ($N_0$), welches einer Strukturtiefe von 0 entspricht,
      -- ein Positiv-Beugungsstruktur-Niveau ($N_1$), welches gegenüber dem Neutral-Beugungsstruktur-Niveau ($N_0$) erhaben ist, und
      -- ein Negativ-Beugungsstruktur-Niveau ($N_2$), welches gegenüber dem Neutral-Beugungsstruktur-Niveau ($N_0$) abgesenkt ist,

   - wobei innerhalb der Gitterperiode (P) das Neutral-Beugungsstruktur-Niveau ($N_0$) eine Erstreckung ($a_0$) längs der Perioden-Laufrichtung (x) aufweist, die kleiner ist als 50 % der Erstreckung der Gitterperiode (P),
   - wobei ein Unterschied zwischen den beiden Ziel-Wellenlängen $\lambda 1$, $\lambda 2$ kleiner ist als 50 %, also gilt: $\lambda 1 - \lambda 2 < 0,5$ $\lambda 1$,
   - wobei $\lambda 1$ die größere Ziel-Wellenlänge und $\lambda 2$ die kleinere Ziel-Wellenlänge ist,
   - **dadurch gekennzeichnet, dass** sich die beiden Ziel-Wellenlängen ($\lambda 1$, $\lambda 2$) um mindestens 1 % unterscheiden.

2. Optische Beugungskomponente nach Anspruch 1, **dadurch gekennzeichnet, dass** das Positiv-Beugungsstruktur-Niveau ($N_1$) und das Negativ-Beugungsstruktur-Niveau ($N_2$) die gleiche Erstreckung (a1 = a2) längs der Perioden-Laufrichtung (x) aufweisen.

3. Optische Beugungskomponente nach Anspruch 1 oder 2, **dadurch gekennzeichnet, dass** das Positiv-Beugungsstruktur-Niveau ($N_1$) und das Negativ-Beugungsstruktur-Niveau ($N_2$) die gleiche absolute Strukturtiefe ($d_0$) relativ zur Referenzebene (d = 0) aufweisen.

4. Optische Beugungskomponente nach einem der Ansprüche 1 bis 3,
   **dadurch gekennzeichnet, dass** der Unterschied zwischen den beiden Ziel-Wellenlängen ($\lambda 1$, $\lambda 2$) größer ist als 5 %.

5. Optische Beugungskomponente nach einem der Ansprüche 1 bis 4,
   **dadurch gekennzeichnet, dass** sich die beiden Ziel-Wellenlängen um mindestens 10 % unterscheiden.

6. Optische Beugungskomponente nach einem der Ansprüche 1 bis 5,
   **dadurch gekennzeichnet, dass** die Gitterperiode (P) längs der Perioden-Laufrichtung (x) eine Erstreckung im Bereich zwischen 0,5 mm und 5 mm aufweist.

7. Optische Beugungskomponente nach einem der Ansprüche 1 bis 6, **gekennzeichnet durch** eine Abfolge der Beugungsstruktur-Niveaus ($N_0$, $N_1$, $N_2$) in der Perioden-Laufrichtung (x) derart, dass sich eine spiegelsymmetrische Anordnung der Beugungsstruktur-Niveaus ($N_0$, $N_1$, $N_2$) ergibt.

8. EUV-Kollektor (24) zum Einsatz in einer EUV-Projektionsbelichtungsanlage mit einer optischen Beugungskomponente (34; 39; 40; 41; 42) nach einem der Ansprüche 1 bis 7.

9. Beleuchtungssystem mit einem EUV-Kollektor (24) nach Anspruch 8 und mit einer Beleuchtungsoptik (6) zur Beleuchtung eines Objektfeldes (4), in dem ein abzubildendes Objekt (10) anordenbar ist, mit EUV-Nutzlicht als Beleuchtungslicht (3).

10. Beleuchtungssystem nach Anspruch 9, **dadurch gekennzeichnet, dass** das Beleuchtungssystem so gestaltet ist, dass eine homogene Verteilung von Strahlung der beiden Ziel-Wellenlängen, die auch als Falschlicht bezeichnet ist, im Bereich von Falschlicht-Abführorten erfolgen kann.

11. Optisches System mit einem Beleuchtungssystem nach Anspruch 9 oder 10 und mit einer Projektionsoptik (7) zur Abbildung des Objektfeldes (4) in ein Bildfeld (8), in welchem ein Substrat (11) anordenbar ist, auf welches ein Abschnitt des abzubildenden Objekts (10) abzubilden ist.

12. Projektionsbelichtungsanlage (1) mit einem optischen System nach Anspruch 11 und mit einer EUV-Lichtquelle (2).

13. Verfahren zur Herstellung eines strukturierten Bauteils mit folgenden Verfahrensschritten:

- Bereitstellen eines Retikels (10) und eines Wafers (11),
- Projizieren einer Struktur auf dem Retikel (10) auf eine lichtempfindliche Schicht des Wafers (11) mithilfe der Projektionsbelichtungsanlage nach Anspruch 12,
- Erzeugen einer Mikro- und/oder Nanostruktur auf dem Wafer (11).

**Claims**

1. Optical diffraction component (34; 39; 40; 41; 42)

- with a periodic grating structure profile with diffraction structures, having exactly three diffraction structure levels ($N_0$, $N_1$, $N_2$) predefining different structure depths (d) relative to a reference plane (d = 0),
- wherein the arrangement of the diffraction structures is such that a wavelength range around two different target wavelengths $\lambda1$, $\lambda2$ diffracted by the grating structure profile has radiation components with three different phases that interfere destructively with one another,
- wherein the diffraction structure levels ($N_0$, $N_1$, $N_2$) predefine a topography of a grating period (P) of the grating structure profile that is repeated regularly along a period running direction (x),
- wherein the three diffraction structure levels ($N_0$, $N_1$, $N_2$) include:

-- a neutral diffraction structure level ($N_0$), which corresponds to a structure depth of 0,
-- a positive diffraction structure level ($N_1$), which is raised relative to the neutral diffraction structure level ($N_0$), and
-- a negative diffraction structure level ($N_2$), which is lowered relative to the neutral diffraction structure level ($N_0$),

- wherein within the grating period (P) the neutral diffraction structure level ($N_0$) has an extent ($a_0$) along the period running direction (x) which is less than 50% of the extent of the grating period (P),
- wherein a difference between the two target wavelengths $\lambda1$, $\lambda2$ is less than 50%, i.e. it holds true that: $\lambda1 - \lambda2 < 0.5\,\lambda1$,
- wherein $\lambda1$ is the larger target wavelength and $\lambda2$ is the smaller target wavelength,
- **characterized in that**
the two target wavelengths ($\lambda1$, $\lambda2$) differ by at least 1%.

2. Optical diffraction component according to Claim 1, **characterized in that** the positive diffraction structure level ($N_1$) and the negative diffraction structure level ($N_2$) have the same extent (a1 = a2) along the period running direction (x).

3. Optical diffraction component according to Claim 1 or 2, **characterized in that** the positive diffraction structure level ($N_1$) and the negative diffraction structure level ($N_2$) have the same absolute structure depth ($d_0$) relative to the reference plane (d = 0).

4. Optical diffraction component according to any of Claims 1 to 3, **characterized in that** the difference between the two target wavelengths ($\lambda1$, $\lambda2$) is greater than 5%.

5. Optical diffraction component according to any of Claims 1 to 4, **characterized in that** the two target wavelengths differ by at least 10%.

6. Optical diffraction component according to any of Claims 1 to 5, **characterized in that** the grating period (P) has an extent in the range of between 0.5 mm and 5 mm along the period running direction (x).

7. Optical diffraction component according to any of Claims 1 to 6, **characterized by** a sequence of the diffraction

structure levels ($N_0$, $N_1$, $N_2$) in the period running direction (x) such that a mirror-symmetrical arrangement of the diffraction structure levels ($N_0$, $N_1$, $N_2$) results.

8. EUV collector (24) for use in an EUV projection exposure apparatus comprising an optical diffraction component (34; 39; 40; 41; 42) according to any of Claims 1 to 7.

9. Illumination system comprising an EUV collector (24) according to Claim 8 and comprising an illumination optical unit (6) for illuminating an object field (4), in which an object (10) to be imaged is arrangeable, with EUV used light as illumination light (3).

10. Illumination system according to Claim 9, **characterized in that** the illumination system is fashioned so as to enable a homogeneous distribution of radiation of the two target wavelengths, which is also referred to as stray light, in the region of stray light removal locations.

11. Optical system comprising an illumination system according to Claim 9 or 10 and comprising a projection optical unit (7) for imaging the object field (4) into an image field (8), in which a substrate (11) is arrangeable, onto which a portion of the object (10) to be imaged is to be imaged.

12. Projection exposure apparatus (1) comprising an optical system according to Claim 11 and comprising an EUV light source (2).

13. Method for producing a structured component, comprising the following method steps:

    - providing a reticle (10) and a wafer (11),
    - projecting a structure on the reticle (10) onto a light-sensitive layer of the wafer (11) with the aid of the projection exposure apparatus according to Claim 12,
    - producing a microstructure and/or nanostructure on the wafer (11).


**Revendications**

1. Composant de diffraction optique (34 ; 39 ; 40 ; 41 ; 42)

    - avec un profil de structure de réseau périodique avec des structures de diffraction, présentant exactement trois niveaux de structure de diffraction ($N_0$, $N_1$, $N_2$) qui définissent différentes profondeurs de structure (d) par rapport à un plan de référence (d = 0),
    - l'agencement des structures de diffraction étant telle qu'une plage de longueurs d'onde autour de deux longueurs d'onde cibles différentes $\lambda 1$, $\lambda 2$, qui sont diffractées par le profil de structure de réseau, présente des composantes de rayonnement avec trois phases différentes qui interfèrent de manière destructive entre elles,
    - les niveaux de structure de diffraction ($N_0$, $N_1$, $N_2$) définissant une topographie d'une période de réseau (P) qui se répète régulièrement le long d'une direction de périodicité (x) du profil de structure de réseau,
    - les trois niveaux de structure de diffraction ($N_0$, $N_1$, $N_2$) comprenant :

        -- un niveau de structure de diffraction neutre ($N_0$) correspondant à une profondeur de structure de 0,
        -- un niveau de structure de diffraction positif ($N_1$) qui est surélevé par rapport au niveau de structure de diffraction neutre ($N_0$), et
        -- un niveau de structure de diffraction négatif ($N_2$) qui est abaissé par rapport au niveau de structure de diffraction neutre ($N_0$),

    - à l'intérieur de la période de réseau (P), le niveau de structure de diffraction neutre ($N_0$) présentant une extension ($a_0$) le long de la direction de périodicité (x) qui est inférieure à 50 % de l'extension de la période de réseau (P),
    - une différence entre les deux longueurs d'onde cibles $\lambda 1$, $\lambda 2$ étant inférieure à 50 %, avec donc : $\lambda 1 - \lambda 2 < 0,5 \lambda 1$,
    - $\lambda 1$ étant la plus grande longueur d'onde cible et $\lambda 2$ la plus petite longueur d'onde cible,
    - **caractérisé en ce que**
    les deux longueurs d'onde cibles (A1, $\lambda 2$) diffèrent d'au moins 1 %.

2. Composant de diffraction optique selon la revendication 1, **caractérisé en ce que** le niveau de structure de diffraction

positif ($N_1$) et le niveau de structure de diffraction négatif ($N_2$) ont la même extension (a1 = a2) le long de la direction de périodicité (x).

3. Composant de diffraction optique selon la revendication 1 ou 2, **caractérisé en ce que** le niveau de structure de diffraction positif ($N_1$) et le niveau de structure de diffraction négatif ($N_2$) présentent la même profondeur de structure absolue ($d_0$) par rapport au plan de référence (d = 0).

4. Composant de diffraction optique selon l'une quelconque des revendications 1 à 3, **caractérisé en ce que** la différence entre les deux longueurs d'onde cibles ($\lambda1$, $\lambda2$) est supérieure à 5 %.

5. Composant de diffraction optique selon l'une quelconque des revendications 1 à 4, **caractérisé en ce que** les deux longueurs d'onde cibles diffèrent d'au moins 10 %.

6. Composant de diffraction optique selon l'une quelconque des revendications 1 à 5, **caractérisé en ce que** la période du réseau (P) présente, le long de la direction de périodicité (x), une extension dans la plage comprise entre 0,5 mm et 5 mm.

7. Composant de diffraction optique selon l'une quelconque des revendications 1 à 6, **caractérisé par** une succession de niveaux de structure de diffraction ($N_0$, $N_1$, $N_2$) dans la direction de périodicité (x) de telle sorte qu'il en résulte un agencement symétrique des niveaux de structure de diffraction ($N_0$, $N_1$, $N_2$).

8. Collecteur EUV (24) destiné à être utilisé dans une installation d'exposition par projection EUV avec un composant de diffraction optique (34 ; 39 ; 40 ; 41 ; 42) selon l'une quelconque des revendications 1 à 7.

9. Système d'éclairage avec un collecteur EUV (24) selon la revendication 8 et une optique d'éclairage (6) pour éclairer un champ d'objet (4) dans lequel un objet à reproduire (10) peut être agencé, avec une lumière utile EUV en tant que lumière d'éclairage (3).

10. Système d'éclairage selon la revendication 9, **caractérisé en ce que** le système d'éclairage est conçu de manière à permettre une répartition homogène du rayonnement des deux longueurs d'onde cibles, également appelé lumière parasite, dans la zone des points d'évacuation de la lumière parasite.

11. Système optique avec un système d'éclairage selon la revendication 9 ou 10 et avec une optique de projection (7) pour reproduire le champ d'objet (4) dans un champ d'image (8) dans lequel peut être agencé un substrat (11) sur lequel doit être reproduite une section de l'objet (10) à reproduire.

12. Installation d'exposition par projection (1) avec un système optique selon la revendication 11 et avec une source de lumière EUV (2).

13. Procédé de fabrication d'un composant structuré comprenant les étapes de procédé suivantes :

   - la mise à disposition d'un réticule (10) et d'une plaquette (11),
   - la projection d'une structure présente sur le réticule (10) sur une couche photosensible de la plaquette (11) à l'aide de l'installation d'exposition par projection selon la revendication 12,
   - la génération d'une micro- et/ou nanostructure sur la plaquette (11).

Fig. 1

Fig. 2

Fig. 3

Fig. 4

Fig. 5

Fig. 6

Fig. 7

Fig. 8

Fig. 9

Fig. 10

Fig. 11

**EP 4 022 365 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2017207401 A1
- WO 2014114405 A2
- EP 1540423 B1
- US 20140131586 A1
- DE 102009044462 A1
- US 9551941 B2
- WO 9613942 A1
- US 5162943 A
- US 20090289205 A1
- DE 102018218981 A1
- DE 102009045096 A1
- DE 102012202675 A1

**In der Beschreibung aufgeführte Nicht-Patentliteratur**

- **T. FEIGL et al.** Multilayer EUV optics with integrated IR-suppression gratings. *2016 EUVL Workshop, Berkeley*, 13 June 2016
- Sub-aperture EUV collector with dual-wavelength spectral purity filter. **T. FEIGL et al.** proceedings of SPIE. IEEE, 16 March 2015, 94220E-94220E
- **VON M. OLIVA et al.** Multilevel blazed gratings in resonance domain: an alternative to the classical fabrication approach. *OPTICS EXPRESS*, 2011, vol. 19 (15), 1473-1475
- **VON M. OLIVA et al.** Highly efficient three-level blazed grating in the resonance domain. *OPTICS LETTERS*, 2010, vol. 35 (16), 2774-2776
- **VON V. KETTUNEN et al.** Diffractive elements designed to suppress unwanted zeroth order due to surface depth error. *Journal of Modern Optics*, 2004, vol. 51 (14), 2111-2123